# EUROPÄISCHE PATENTSCHRIFT

(11) **EP 0 354 254 B1**
(45) Veröffentlichungstag und Bekanntmachung des Hinweises auf die Patenterteilung: **01.12.1993**
(21) Anmeldenummer: 88112908.4
(22) Anmeldetag: 08.08.1988
(51) Int. Cl.: H04Q 3/52, H03K 17/693

(54) **Breitbandsignal-Koppeleinrichtung**
Coupling device for broad-band signals
Dispositif de couplage pour signaux à large bande

(43) Veröffentlichungstag der Anmeldung: 14.02.1990
(73) Patentinhaber: SIEMENS AKTIENGESELLSCHAFT, 80333 München (DE)
(72) Erfinder: Trumpp, Gerhard, Dipl.-Ing., D-8039 Puchheim (DE); Wolkenhauer, Jan, Dipl.-Ing., D-8000 München 70 (DE)

(56) Entgegenhaltungen:
- EP-A- 0 262 479
- EP-A- 0 264 046
- US-A- 4 621 202
- US-A- 4 645 944

## Beschreibung

Moderne Entwicklungen der Fernmeldetechnik führen zu diensteintegrierenden Nachrichtenübertragungs- u. -vermittlungssystemen für Schmalband- und Breitband-Kommunikationsdienste, die als Übertragungsmedium im Bereich der Teilnehmeranschlußleitungen Lichtwellenleiter vorsehen, über die sowohl die Schmalbandkommunikationsdienste, wie insbesondere 64-kbit/s-Digital-Telefonie, als auch Breitbandkommunikationsdienste, wie insbesondere 140-Mbit/s-Bildtelefonie, geführt werden, wobei in den Vermittlungsstellen auch (vorzuzgsweise gemeinsame Steuereinrichtungen aufweisende) Schmalbandsignal-Koppeleinrichtungen und Breitbandsignal-Koppeleinrichtungen nebeneinander vorgesehen sein können (DE-C-24 21 002).

Eine (z.B. aus EP-A1-0 262 479) bekannte Breitbandsignal-Koppeleinrichtung weist eine Koppelpunktmatrix in FET-Technik auf, deren Koppelelemente jeweils mit einem an seiner Steuerelektrode mit einem Durchschalte- bzw. Sperrsignal beaufschlagten, mit einer Hauptelektrode an die zugehörige Matrixausgangsleitung angeschlossenen Schalter-Transistor gebildet sind,
wobei die Koppelelemente jeweils einen mit dem Schalter-Transistor eine Serienschaltung bildenden Vorschalt-Transistor aufweisen,
der mit seiner Steuerelektrode an die zugehörige Matrixeingangsleitung angeschlossen ist und dessen der Serienschaltung abgewandte Hauptelektrode über einen Abtast-Transistor mit dem einen Anschluß der Betriebsspannungsquelle verbunden ist, mit deren anderen Anschluß die jeweilige Matrixausgangsleitung über einen Vorlade-Transistor verbunden ist,
und wobei Vorlade-Transistor und Abtast-Transistor gegensinnig zueinander jeweils an ihrer Steuerelektrode mit einem eine Bit-Durchschaltezeitspanne in eine Vorladephase und die eigentliche Durchschaltephase unterteilenden Koppelfeld-Ansteuer-Takt beaufschlagt sind, so daß in jeder Vorphase bei gesperrtem Abtast-Transistor die Matrixausgangsleitung über den Vorlade-Transistor zumindest angenähert auf das an dem genannten anderen Anschluss der Betriebsspannungsquelle herrschende Potential geladen wird.

Diese bekannte Breitbandsignal-Koppeleinrichtung, die koppelelement-individuelle Abtasttransistoren oder matrixeingangsleitungs- oder matrixausgangsleitungs-individuelle Abtast-Transistoren aufweisen kann, benötigt zur Ansteuerung dieser Abtast-Transistoren eigene, die Koppelpunktmatrix durchziehende Taktleitungen, was einen entsprechenden Flächenbedarf erfordert und eine entsprechende kapazitive Belastung der Matrixausgangsleitungen mit sich bringt; Taktverteilung und Kopplungen zwischen Matrixeingangsleitungen und Matrixausgangsleitungen erfordern zur Gewährleistung einer ausreichenden Störsicherheit ausreichend große Signalamplituden auf den Matrixausgangsleitungen, was mit einem relativ hohen Leistungsverbrauch verbunden ist.

Die Erfindung stellt sich nun die Aufgabe, einen Weg zu einer Breitbandsignal-Koppeleinrichtung mit begrenzter Verlustleistung bei hinreichender Störsicherheit aufzuzeigen, in der solche Nachteile vermieden sind.

Die Erfindung betrifft eine Breitbandsignal-Koppeleinrichtung mit einer Koppelpunkt-Matrix in FET-Technik,
deren Eingänge jeweils mit einer Eingangstreiberschaltung versehen sein können,
deren Ausgänge jeweils mit einer Ausgangsverstärkerschaltung versehen sein können und
deren jeweils von einer Halte-Speicherzelle gesteuerte Koppelelemente jeweils mit einer **Serienschaltung** eines an seiner Steuerelektrode mit einem Durchschalte- bzw. Sperrsignal beaufschlagten Schalter-Transistors und eines mit seiner Steuerelektrode an die zugehörige Matrixeingangsleitung angeschlossenen Eingangs-Transistors gebildet sind, **die** mit der der Serienschaltung abgewandten Hauptelektrode des einen Transistors an die zugehörige Matrixausgangsleitung angeschlossen ist, wobei die Matrixausgangsleitung mit einer Vorladepotentialquelle über eine Vorladeschaltung verbunden ist, die mit einem Entriegelungseingang an die Taktsignalleitung eines die Vorladephase einer in eine solche Vorladephase und die übrige Bit-Durchschaltezeitspanne unterteilten Bit-Durchschaltezeitspanne definierenden Vorladetaktsignals angeschlossen ist, so daß die Matrixausgangsleitung in jeder Vorladephase auf ein Vorladepotential geladen wird; diese Breitbandsignal-Koppeleinrichtung ist erfindungsgemäß dadurch gekennzeichnet, daß die der Serienschaltung abgewandte Hauptelektrode des anderen Transistors kontinuierlich mit einem Anschluß der Betriebsspannungsquelle verbunden ist.

Die Erfindung bringt neben dem Vorteil, zusätzliche Taktleitungen zu vermeiden und ggf. die ohnehin erforderliche Betriebsspannungsversorgung der koppelpunktindividuellen Halte-Speicherzelle für die Speisung des von dieser Halte-Speicherzelle gesteuerten Koppelelements mitausnutzen zu können, den weiteren Vorteil mit sich, daß die Ausgangsleitung mit sehr kleinem Signalhub von z.B. 1 V bei einer Betriebsspannung von z.B. 5 V betrieben werden kann, was eine entsprechende Reduzierung der aufzuwendenden Verlustleistungen mit sich bringt; zugleich bringt die mögliche Signalhubreduzierung auf der Matrixausgangsleitung auch eine Reduzierung von durch Stromspitzen bedingten Störungen der Betriebsspannung der Breitbandsignal-Koppeleinrichtung mit sich.

Dabei kann in weiterer Ausgestaltung der Erfindung die der Serienschaltung abgewandte Hauptelektrode des anderen Transistors über einen an seiner Steuerelektrode mit dem Ausgang einer matrixausgangsleitungs-individuellen Ausgangsverstärkerschaltung verbundenen matrixausgangsleitungs-individuellen Transistor mit dem einen Anschluß der Betriebsspannungsquelle verbunden sein. Hierbei wird bei einer entsprechenden Signalzustandsänderung am Ausgang der Ausgangsverstärkerschaltung der matrixausgangsleitungs-individuelle Transistor gesperrt, so daß eine weitere Umladung der Ausgangsleitung vermieden wird und der Signalhub somit begrenzt wird.
In weiterer Ausgestaltung der Erfindung kann die Transistor-Serienschaltung jedes Koppelelements mit ihrem Eingangs-Transistor an der Matrixausgangsleitung liegen.
Alternativ dazu ist es aber möglich, daß in weiterer Ausgestaltung der Erfindung die Transistor-Serienschaltung jedes Koppelelements mit ihrem Schalter-Transistor an der Matrixausgangsleitung liegt, was eine kapazitive Belastung der Matrixausgangsleitung durch die Kanalkapazität der Vorschalt-Transistoren nichtdurchgeschalteter Koppelelemente vermeidet.

Weitere Besonderheiten der Erfindung werden aus der nachfolgenden näheren Erläuterung der Erfindung anhand der Zeichnung ersichtlich. Dabei zeigen
FIG 1 das Schema einer Breitband-Koppeleinrichtung und
FIG 2 bis FIG 8 Einzelheiten ihrer schaltungstechnischen Realisierung gemäß der Erfindung.

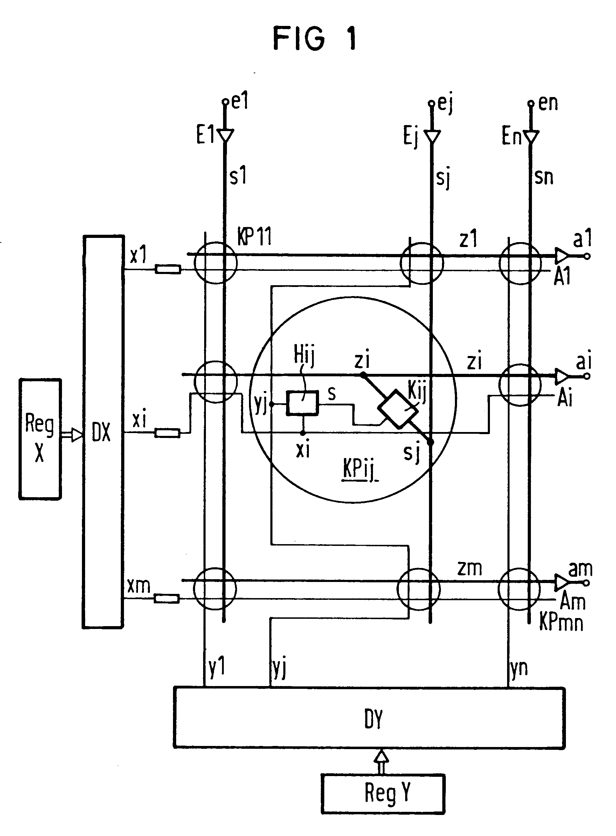

In der Zeichnung FIG 1 ist schematisch in zum Verständnis der Erfindung erforderlichem Umfange eine Breitbandsignal-Koppeleinrichtung skizziert, an deren zu Spaltenleitungen sl...sj...sn einer Koppelpunktmatrix führenden Eingängen el...ej...en Eingangstreiberschaltungen El...Ej...En vorgesehen sind und deren von Zeilenleitungen zl...zi...zm der Koppelpunktmatrix erreichte Ausgänge al...ai...am mit Ausgangsverstärkerschaltungen Al...Ai...Am versehen sind.
Die Koppelpunktmatrix weist Koppelpunkte KPll...KPij...KPmn auf, deren Koppelelemente, wie dies beim Koppelpunkt KPij für dessen Koppelelement Kij weiter ins Einzelne gehend angedeutet ist, jeweils von einer koppelpunktindividuellen Halte-Speicherzelle Hij (beim Koppelpunkt KPij) gesteuert sein können, deren Ausgang s zum Steuereingang des jeweiligen Koppelelements (Kij beim Koppelpunkt KPij) führt.

Die Halte-Speicherzellen ... Hij... werden gemäß FIG 1 durch zwei Ansteuerdecoder, nämlich einen Zeilendecoder DX und einen Spaltendecoder DY, über entsprechende Ansteuerleitungen xl...xi...xm; yl...yj...yn in zwei Koordinaten angesteuert.
Dazu mögen, wie dies aus FIG 1 ersichtlich ist, die beiden Ansteuerdecoder DX, DY von Eingangsregistern Reg X, Reg Y her jeweils mit einer einer Matrixreihe (Zeile bzw.Spalte) von Koppelpunkten gemeinsamen Koppelpunktzeilen- bzw. Koppelpunktspalten-Adresse beaufschlagbar sein, auf die hin sie jeweils an der der jeweiligen Koppelpunktreihen-Adresse entsprechenden Ansteuerleitung jeweils ein "1"-Ansteuersignal abgeben. Das Zusammentreffen eines Zeilenansteuersignals "1" und eines Spaltenansteuersignals "1" am Kreuzungspunkt der betreffenden Matrixzeile mit der betreffenden Matrixspalte beim Aufbau einer entsprechenden Verbindung bewirkt dann eine Aktivierung der dort befindlichen Halte-Speicherzelle, beispielsweise der Speicherzelle Hij, mit der Folge, daß das von der betreffenden Halte-Speicherzelle (Hij) gesteuerte Koppelelement, im Beispiel das Koppelelement Kij, leitend wird.

Damit das im Beispiel betrachtete Koppelelement Kij bei einem Abbau der betreffenden Verbindung wieder gesperrt wird, wird wiederum der Ansteuerdecoder DX vom Eingangsregister Reg X mit der betreffenden Zeilenadresse beaufschlagt, so daß der Zeilendecoder DX wiederum auf seiner Ausgangsleitung xi ein Zeilenansteuersignal "1" abgibt, und zugleich wird der Spaltendecoder DY von seinem Eingangsregister Reg Y her beispielsweise mit einer Leeradresse oder mit der Adresse einer Spalte von unbeschalteten Koppelpunkten beaufschlagt, so daß er auf seiner Ausgangsleitung yj ein Spaltenansteuersignal "0" abgibt; das Zusammentreffen von Zeilenansteuersignal "1" und Spaltenansteuersignal "0" bewirkt dann die Rücksetzung der Halte-Speicherzelle Hij mit der Folge, daß das von ihr gesteuerte Koppelelement Kij gesperrt wird.

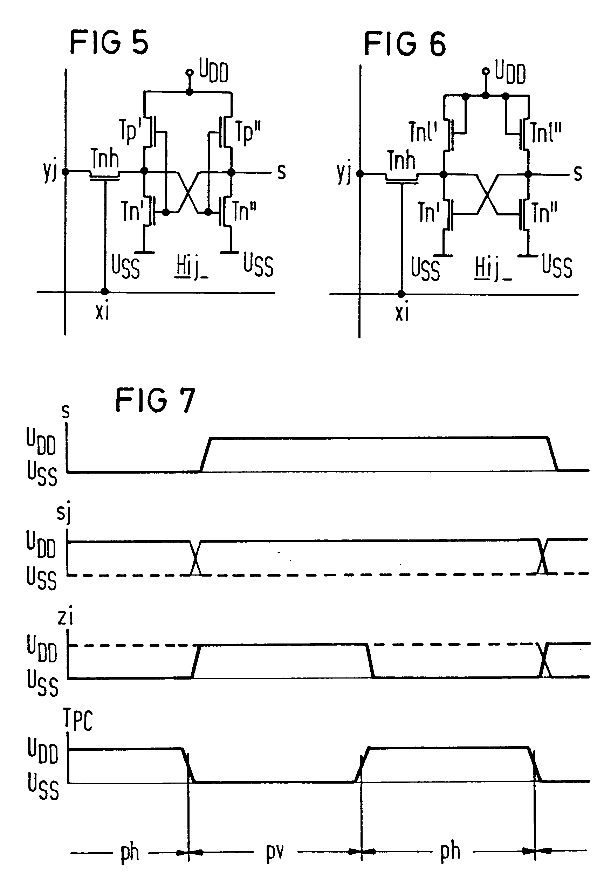

Die Halte-Speicherzellen ...Hij... können in an sich bekannter Weise ausgebildet sein; so können die Halte-Speicherzellen beispielsweise, wie dies z.B. aus EP-A-0 238 834 bekannt und auch in FIG 5 und FIG 6 skizziert ist, mit einem n-Kanal-Transistor Tnh und zwei kreuzgekoppelten Inverterschaltungen (C-MOS-Inverterschaltungen Tp′,Tn′; Tp˝,Tn˝ in FIG 5, n-MOS-Inverterschaltungen Tnl′,Tn′; Tnl˝,Tn˝ in FIG 6) gebildet sein, wobei eine Inverterschaltung eingangsseitig mit dem zugehörigen Decoderausgang yj des einen Ansteuerdecoders über den n-Kanal-Transistor Tnh verbunden ist, der seinerseits an seiner Steuerelektrode mit dem Ausgangssignal des zugehörigen Decoderausgangs xi des anderen Ansteuerdecoders beaufschlagt ist, und wobei eine Inverterschaltung ausgangsseitig zum Steuereingang s des zugehörigen Koppelelements führt.

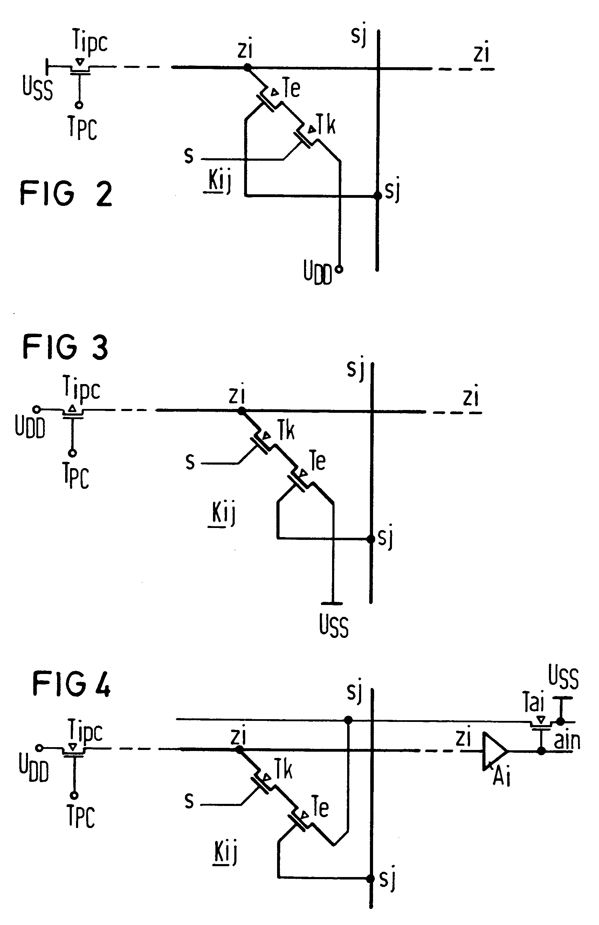

Wie die Koppelelemente ...Kij... schaltungstechnisch realisiert sein können, wird in FIG 2, FIG 3 und FIG 4 verdeutlicht: Die Koppelelemente ...Kij... sind jeweils mit einer **Serienschaltung** eines an seiner Steuerelektrode von der Halte-Speicherzelle her mit einem Durchschalte- bzw. Sperrsignal beaufschlagten Schalter-Transistors Tk und eines mit seiner Steuerelektrode an die zugehörige Matrixeingangsleitung sj angeschlossenen Eingangs-Transistors Te gebildet, **die** mit der der Serienschaltung abgewandten Hauptelektrode des einen Transistors Tk (in FIG 3 und FIG 4) oder Te (in FIG 2) an die zugehörige Matrixausgangsleitung zi angeschlossen ist.
Dabei ist die Matrixausgangsleitung zi über eine Vorladeschaltung mit einer Vorladepotentialquelle verbunden, von der her die Matrixausgangsleitung zi auf ein zwischen den beiden Betriebspotentialen liegendes Vorladepotential oder auch auf eines der beiden Betriebspotentiale selbst aufladbar ist. Eine Vorladepotentialquelle für ein zwischen den beiden Betriebspotentialen liegendes Vorladepotential kann insbesondere in prinzipiell (z.B. aus EP-A-0 249 837) bekannter Weise mit einem rückgekoppelten C-MOS-Inverter gebildet sein, über den jeweils in einer Vorladephase einer Bit-Durchschaltezeitspanne die Matrixausgangsleitung zumindest angenähert auf das der Schaltschwelle des Inverters entsprechende Potential geladen wird. Dementsprechend ist in den in FIG 2 bis FIG 4 dargestellten Ausführungsbeispielen die Matrixausgangsleitung zi mit dem einen Anschluß (U_{SS} in FIG 2; U_{DD} in FIG 3, FIG 4) der Betriebsspannungsquelle U_{DD}-U_{SS} über eine Vorladeschaltung verbunden, die, wie dies auch aus FIG 2 bis FIG 4 ersichtlich ist, in an sich (z.B. aus EP-A-0 262 479) bekannter Weise mit einem mit seiner Steuerelektrode an einer Vorladetaktleitung T_{PC} liegenden Vorlade-Transistor Tipc gebildet ist.
Die der Serienschaltung abgewandte Hauptelektrode des anderen Transistors Te (in FIG 3 und FIG 4) bzw. Tk (in FIG 2) ist kontinuierlich, d.h. nicht taktgesteuert, mit dem anderen Anschluß U_{SS}, Masse (in FIG 3 und FIG 4) bzw. U_{DD} (in FIG 2) der Betriebsspannungsquelle verbunden, wozu bei unmittelbarer Verbindung gemäß FIG 2 und FIG 3 der entsprechende Betriebsspannungs-Anschluß (U_{SS}, Masse bzw. U_{DD} in FIG 5 und FIG 6) der koppelpunkt-individuellen Halte-Speicherzelle Hᵢⱼ (in FIG 1, FIG 5 und FIG 6) genutzt werden kann, so daß die ohnehin erforderliche Betriebsspannungsversorgung der koppelpunktindividuellen Halte-Speicherzelle für die Speisung des von dieser Halte-Speicherzelle gesteuerten Koppelelements mitausgenutzt wird. Im Ausführungsbeispiel gemäß FIG 4 ist die der Serienschaltung abgewandte Hauptelektrode des anderen Transistors (Te) über einen an seiner Steuerelektrode mit dem Ausgang ai einer matrixausgangsleitungs-individuellen Ausgangsverstärkerschaltung Ai verbundenen matrixausgangsleitungs-individuellen Transistor Tai mit dem anderen Anschluß U_{SS} der Betriebsspannungsquelle verbunden. Hierbei wird bei einer entsprechenden Signalzustandsänderung am Ausgang ai der Ausgangsverstärkerschaltung Ai der matrixausgangsleitungs-individuelle Transistor Tai gesperrt, so daß eine weitere Umladung der Ausgangsleitung vermieden wird und der Signalhub somit begrenzt wird.

Wie dies aus FIG 2 ersichtlich ist, kann die Transistor-Serienschaltung Tk-Te jedes Koppelelements Kij mit ihrem Eingangs-Transistor Te an der Matrixausgangsleitung zi liegen. Dabei ist der Eingangs-Transistor Te, von der Matrixausgangsleitung zi her gesehen, gewissermaßen transparent, so daß Signalzustandsänderungen auf der Matrixeingangsleitung sj über die Kanalkapazität des Eingangs-Transistors Te auch bei gesperrtem Koppelpunkt Kij auf die Matrixausgangsleitung zi durchgreifen.
Dieser Durchgriff kann vermieden werden, wenn in der Transistor-Serienschaltung Tk-Te jedes Koppelelements Kij die Reihenfolge von Eingangs-Transistor Te und Schalter-Transistor Tk vertauscht ist: Wie dies auch aus FIG 3 und FIG 4 ersichtlich ist, liegt dann die Transistor-Serienschaltung Tk-Te jedes Koppelelements Kij mit ihrem Schalter-Tranistor Tk an der Matrixausgangsleitung zi.

Als Transistoren wird man vorzugsweise n-Kanal-Transistoren einsetzen. Dementsprechend sind in den Ausführungsbeispielen gemäß FIG 2 und FIG 4 die Transistoren einheitlich vom n-Kanal-Typ, während im Ausführungsbeispiel gemäß FIG 3 die in den Koppelelementen ...Kij... vorgesehenen Transistoren (Te, Tk) vom n-Kanal-Typ sind und die Vorlade-Transistoren (Tipc) vom p-Kanal-Typ.

Durch ein entsprechendes, die Steuerelektrode jedes Vorlade-Transistors (Tipc) beaufschlagendes Vorladetaktsignal T_{PC} wird bewirkt, daß in jeder Vorladephase pv (in FIG 7) einer durch das Vorladetaktsignal in eine solche Vorladephase pv und die übrige Bit-Durchschaltezeitspanne (ph in FIG 7) unterteilten Bitperiode jeder Vorlade-Transistor (Tipc) leitend ist, so daß während der Vorphase pv die Matrixausgangsleitungen ...zi... über den jeweiligen Vorlade-Transistor (Tipc in FIG 2 bis FIG 4) zumindest angenähert auf das jeweilige Betriebspotential (U_{SS} in FIG 2; U_{DD} in FIG 3_{DD} und FIG 4) geladen wird. Ein solches in den Ausführungsbeispielen gemäß FIG 2 und FIG 3 geeignetes Vorladetaktsignal ist in FIG 7 in Zeile T_{PC} dargestellt; für das Ausführungsbeispiel gemäß FIG 4 ist das invertierte Vorladetaktsignal zu verwenden.

In der darauffolgenden Hauptphase ph (siehe FIG 7, unten), werden im Beispiel durch ein "HIGH"-Vorladetaktsignal T_{PC} (siehe FIG 7, Zeile T_{PC}) die Vorlade-Transistoren Tipc (in FIG 2 bis FIG 4) gesperrt. Ist nun in einem Koppelelement Kij dessen vorzugsweise durch einen n-Kanal-Transistor gegebener Schalt-Transistor Tk (in FIG 2 bis FIG 4) aufgrund eines am Steuereingang s anliegenden (im Beispiel "HIGH"-)Durchschaltesignals (siehe FIG 7, Zeile s) leitend und befindet sich damit der Koppelpunkt im Durchschaltezustand, so wird jetzt je nach dem dem durchzuschaltenden Bit entsprechenden, auf der betreffenden Matrixeingangsleitung (Spaltenleitung) ...sj... herrschenden Signalzustand die mit dieser Matrixeingangsleitung (Spaltenleitung) ... sj... über das betreffende Koppelelement Kij verbundene Matrixausgangsleitung (Zeilenleitung) zi entladen werden oder auf dem in der Vorphase pv angenommenen Betriebspotential verbleiben:
Herrscht auf der betreffenden Matrixeingangsleitung (Spaltenleitung) sj der "LOW"-Signalzustand, wie dies in FIG 7, Zeile sj, mit einer gestrichelten Linie angedeutet ist, und ist dementsprechend der (n-Kanal-)Eingangs-Transistor Te (in FIG 2 bis FIG 4) des betreffenden Koppelelements Kij gesperrt, so wird die betreffende Matrixausgangsleitung (Zeilenleitung) zi über dieses Koppelelement Kij nicht entladen, sondern behält unter der Voraussetzung, daß kein anderer zu dieser Matrixausgangsleitung (Zeilenleitung) zi führender Koppelpunkt sich im Durchschaltezustand befindet, den Vorlade-Potentialzustand (U_{SS} im Ausführungsbeispiel gemäß FIG 2; U_{DD} in den Ausführungsbeispielen gemäß FIG 3 und FIG 4) bei.

Herrscht dagegen auf der gerade betrachteten Matrixeingangsleitung (Spaltenleitung) sj der "HIGH"-Signalzustand, wie dies in FIG 7, Zeile sj, mit einer durchgezogenen Linie angedeutet ist, und ist dementsprechend der Eingangs-Transistor Te (in FIG 2 bis FIG 4) des betrachteten Koppelelements Kij ebenso wie der Schalter-Transistor Tk leitend, so wird die Matrixausgangsleitung (Zeilenleitung) zi über dieses Koppelelement Kij entladen und auf das komplementäre Betriebspotential (U_{DD} im Ausführungsbeispiel gemäß FIG 2; Uₛₛ in den Ausführungsbeispielen gemäß FIG 3 und FIG 4) gezogen.

Über einen von seinem Steuereingang s her entriegelten Koppelpunkt wird somit das jeweilige Eingangssignal jeweils invertiert durchgeschaltet.

## Patentansprüche

1. Breitbandsignal-Koppeleinrichtung mit einer Koppelpunkt-Matrix in FET-Technik,
deren Eingänge (ej-sj) jeweils mit einer Eingangstreiberschaltung (Ej) versehen sein können,
deren Ausgänge (zi-ai) jeweils mit einer Ausgangsverstärkerschaltung (Ai) versehen sein können und
deren jeweils von einer Halte-Speicherzelle (Hij) gesteuerte Koppelelemente (Kij) jeweils mit einer **Serienschaltung** eines an seiner Steuerelektrode mit einem Durchschalte- bzw. Sperrsignal beaufschlagten Schalter-Transistors (Tk) und eines mit seiner Steuerelektrode an die zugehörige Matrixeingangsleitung (sj) angeschlossenen Eingangs-Transistors (Te) gebildet sind, **die** mit der der Serienschaltung abgewandten Hauptelektrode des einen Transistors (Tk oder Te) an die zugehörige Matrixausgangsleitung (zi) angeschlossen ist,
wobei die Matrixausgangsleitung (zi) mit einer Vorladepotentialquelle (U_{DD}) über eine Vorladeschaltung (Tipc) verbunden ist, die mit einem Entriegelungseingang an die Taktsignalleitung (T_{PC}) eines die Vorladephase (pv) einer in eine solche Vorladephase (pv) und die übrige Bit-Durchschaltezeitspanne unterteilten Bit-Durchschaltezeitspanne definierenden Vorladetaktsignals angeschlossen ist, so daß die Matrixausgangsleitung (zi) in jeder Vorladephase (pv) auf ein Vorladepotential geladen wird,
**dadurch gekennzeichnet,**
daß die der Serienschaltung abgewandte Hauptelektrode des anderen Transistors (Te oder Tk) kontinuierlich mit einem Anschluß (U_{SS}, Masse) der Betriebsspannungsquelle verbunden ist.

2. Breitbandsignal-Koppeleinrichtung nach Anspruch 1,
**dadurch gekennzeichnet**,
daß die der Serienschaltung abgewandte Hauptelektrode des anderen Transistors (Te oder Tk) über einen an seiner Steuerelektrode mit dem Ausgang (ai) einer matrixausgangsleitungs-individuellen Ausgangsverstärkerschaltung (Ai) verbundenen matrixausgangsleitungs-individuellen Transistor (Tai) mit dem einen Anschluß (U_{SS}, Masse) der Betriebsspannungsquelle verbunden ist.

3. Breitbandsignal-Koppeleinrichtung nach Anspruch 1 oder 2,
**dadurch gekennzeichnet,**
daß die Transistor-Serienschaltung (Tk-Te) jedes Koppelelements (Kij) mit ihrem Schalter-Transistor (Tk) an der Matrixausgangsleitung (zi) liegt.

4. Breitbandsignal-Koppeleinrichtung nach Anspruch 1 oder 2,
**dadurch gekennzeichnet,**
daß die Transistor-Serienschaltung (Tk-Te) jedes Koppelelements (Kij) mit ihrem Eingangs-Transistor (Te) an der Matrixausgangsleitung (zi) liegt.

## Claims

1. Broadband signal switching network having a crosspoint matrix in FET technology,
the inputs (ej-sj) of which can each be provided with an input driver circuit (Ej),
the outputs (zi-ai) of which can each be provided with an output amplifier circuit (Ai), and
the switching elements (Kij) of which, controlled by a holding memory cell (Hij) in each case, are each formed by a series circuit of a switching transistor (Tk) whose control electrode receives a through-connect signal or inhibit signal and an input transistor (Te) that is connected by its control electrode to the associated matrix input line (sj), which series circuit is connected to the associated matrix output line (zi) by the main electrode of the one transistor (Tk or Te) remote from the series circuit,
in which the matrix output line (zi) is connected to a pre-charging potential source (U_{DD}) via a pre-charging circuit (Tipc), which is connected by a release input to the clock signal line (T_{PC}) of a pre-charging clock signal that defines the pre-charging phase (pv) of a bit through-connection time period which is subdivided into such a pre-charging phase (pv) and the remaining bit through-connection time period, so that the matrix output line (zi) is charged to a pre-charging potential in every pre-charging phase (pv),
characterized in that the main electrode of the other transistor (Te or Tk) remote from the series circuit is continuously connected to a terminal (U_{SS}, ground) of the operating voltage source.

2. Broadband signal switching network according to Claim 1, characterized in that the main electrode of the other transistor (Te or Tk) remote from the series circuit is connected to one terminal (U_{SS}, ground) of the operating voltage source via a transistor (Tai) which is individually associated with the matrix output line and which is connected at its control electrode to the output (ai) of an output amplifier circuit (Ai) individually associated with the matrix output line.

3. Broadband signal switching network according to Claim 1 or 2, characterized in that the transistor series circuit (Tk-Te) of each switching element (Kij) is connected by its switching transistor (Tk) to the matrix output line (zi).

4. Broadband signal switching network according to Claim 1 or 2, characterized in that the transistor series circuit (Tk-Te) of each switching element (Kij) is connected by its input transistor (Te) to the matrix output line (zi).

## Revendications

1. Dispositif de couplage de signaux à large bande, comportant une matrice de points de couplage en technique FET,
dont les entrées (ej-sj) peuvent être munies respectivement d'un circuit d'attaque d'entrée (Ej),
dont les sorties (zi-ai) peuvent être munies respectivement d'un circuit amplificateur de sortie (Ai) et
dont les éléments de couplage (Kij) commandés respectivement par une cellule de mémoire (Hij) de maintien, sont formés par un circuit série constitué d'un transistor de commutation (Tk) chargé, au niveau de son électrode de commande, par un signal de connexion ou de blocage, et d'un transistor d'entrée (Te) relié, par son électrode de commande, à la ligne d'entrée de la matrice (sj) associée, le circuit série étant relié à la ligne de sortie de la matrice (zi) associée, par l'électrode principale, opposée au circuit série, de l'un des transistors (Tk ou Te),
du type dans lequel la ligne de sortie de matrice (zi) est reliée une source de potentiel de charge (U_{DD}), par l'intermédiaire d'un circuit de charge (Tipc) qui est relié, par une entrée de déblocage, à la ligne (T_{pc}) de signal d'horloge d'un signal de charge d'horloge définissant la phase de charge (pv) d'un intervalle de temps de passage d'un bit séparé en une phase de charge (pv) de ce genre et en l'intervalle de temps usuel de passage d'un bit, de telle sorte que la ligne de sortie de matrice (zi) est chargée dans chaque phase de charge (pv) par un potentiel de charge,
caractérisé en ce que
l'électrode principale, opposée au circuit de série, de l'autre transistor (Te ou Tk) est reliée en continu à une borne (U_{SS}, Masse) de la source de tension de service.

2. Dispositif de couplage de signaux à large bande suivant la revendication 1,
caractérisé en ce que
l'électrode principale de l'autre transistor (Te ou Tk), qui est opposée au circuit série, est reliée à l'une des bornes (U_{SS}, Masse) de la source de tension de service, par l'intermédiaire d'un transistor (Tai) qui est propre à la ligne de sortie de la matrice et qui est relié, par son êlectrode de commande, à la sortie (ai) d'un circuit amplificateur de sortie (Ai) propre à la ligne de sortie de matrice.

3. Dispositif de couplage de signaux à large bande suivant la revendication 1 ou 2,
caractérisé en ce que
le circuit série à transistors (Tk-Te) de chaque élément de couplage (Kij) est relié, par son transistor de commutation (Tk), à la ligne de sortie de matrice.

4. Dispositif de couplage de signaux à large bande suivant la revendication 1 ou 2,
caractérisé en ce que le circuit série à transistors (Tk-Te) de chaque élément de couplage (Kij) est relié, par son transistor d'entrée (Te), à la ligne de sortie de la matrice.
